(19) Europäisches Patentamt / European Patent Office / Office européen des brevets

(11) **EP 3 460 501 B1**

(12) **EUROPÄISCHE PATENTSCHRIFT**

(45) Veröffentlichungstag und Bekanntmachung des Hinweises auf die Patenterteilung:
**24.11.2021 Patentblatt 2021/47**

(51) Int Cl.:
**G01R 33/483** *(2006.01)*     **G01R 33/561** *(2006.01)*
G01R 33/565 *(2006.01)*     G01R 33/563 *(2006.01)*

(21) Anmeldenummer: **17192871.6**

(22) Anmeldetag: **25.09.2017**

(54) **SCHICHT-MULTIPLEXING-MR-VERFAHREN**

MR LAYER-MULTIPLEXING METHOD

PROCÉDÉ RM DE MULTIPLEXAGE DE COUCHE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**27.03.2019 Patentblatt 2019/13**

(73) Patentinhaber: **Siemens Healthcare GmbH**
**91052 Erlangen (DE)**

(72) Erfinder:
• **Carinci, Flavio**
**91052 Erlangen (DE)**
• **Zeller, Mario**
**91054 Erlangen (DE)**

(56) Entgegenhaltungen:
**DE-A1-102016 200 975     JP-A- 2005 040 464**
**US-A1- 2003 016 015     US-A1- 2016 069 974**

• **ZHU K. ET AL.: "Simultaneous Multi-slice Flyback Echo Planar Imaging with Auto-calibration", PROCEEDINGS OF THE INTERNATIONAL SOCIETY FOR MAGNETIC RESONANCE IN MEDICINE, 21ST ANNUAL MEETING, 7. April 2013 (2013-04-07), Seite 0125, XP040627726, Salt Lake City, Utah, USA**

EP 3 460 501 B1

**Beschreibung**

Die Erfindung betrifft ein Verfahren zur Erzeugung von Messdaten von mindestens zwei sich nicht überschneidenden Schichten eines Untersuchungs-objektes mittels Magnetresonanztechnik unter Verwendung einer Messsequenz, die Messpunkte auf einer k-Raumtrajektorie festlegt und Echosignale aus mindestens zwei sich nicht überschneidenden Schichten simultan aufnimmt.

Die Magnetresonanz-Technik (im Folgenden steht die Abkürzung MR für Magnetresonanz) ist eine bekannte Technik, mit der Bilder vom Inneren eines Untersuchungsobjektes erzeugt werden können. Vereinfacht ausgedrückt wird hierzu das Untersuchungsobjekt in einem Magnetresonanzgerät in einem vergleichsweise starken statischen, homogenen Grundmagnetfeld, auch $B_0$-Feld genannt, mit Feldstärken von 0,2 Tesla bis 7 Tesla und mehr positioniert, so dass sich dessen Kernspins entlang des Grundmagnetfeldes orientieren. Zum Auslösen von Kernspinresonanzen werden hochfrequente Anregungspulse (RF-Pulse) in das Untersuchungsobjekt eingestrahlt, die ausgelösten Kernspinresonanzen als sogenannte k-Raumdaten gemessen und auf deren Basis MR-Bilder rekonstruiert oder Spektroskopiedaten ermittelt. Zur Ortskodierung der Messdaten werden dem Grundmagnetfeld schnell geschaltete magnetische Gradientenfelder überlagert. Die aufgezeichneten Messdaten werden digitalisiert und als komplexe Zahlenwerte in einer k-Raum-Matrix abgelegt. Aus der mit Werten belegten k-Raum-Matrix ist z.B. mittels einer mehrdimensionalen Fourier-Transformation ein zugehöriges MR-Bild rekonstruierbar.

Um bei MR-Messungen das Signal-zu-Rausch-Verhältnis (SNR, engl. "signal to noise ratio") zu verbessern oder eine Bewegungs- und/oder Flusssensitivität der Messung zu verringern, ist es bei vielen Aufnahmen bereits üblich, Messdaten mehrfach aufzunehmen, um Mittelungen an den Messdaten oder z.B. an den rekonstruierten Bilddaten vornehmen zu können (engl. "averaging").

Der Wunsch nach immer schnelleren MR-Aufnahmen im klinischen Umfeld führt momentan zu einer Renaissance von Verfahren, bei denen mehrere Bilder simultan aufgenommen werden. Allgemein lassen sich diese Verfahren dadurch charakterisieren, dass zumindest während eines Teils der Messung gezielt Transversalmagnetisierung von zumindest zwei Schichten gleichzeitig für den Bildgebungsprozess genutzt wird ("Multi-Schicht-Bildgebung", "Schicht-Multiplexing"). Im Gegensatz dazu wird bei der etablierten "Mehrschicht-Bildgebung" das Signal von zumindest zwei Schichten alternierend, d. h. vollständig unabhängig voneinander mit entsprechender längerer Messzeit aufgenommen.

Bekannte Verfahren hierzu sind beispielsweise die sogenannte Hadamard-Kodierung, Verfahren mit simultaner Echo-Refokussierung, Verfahren mit Breitband-Datenaufnahme oder auch Verfahren, die eine parallele Bildgebung in SchichtRichtung einsetzten. Zu den letztgenannten Verfahren gehören beispielsweise auch die CAIPIRINHA-Technik, wie sie von Breuer et al. in "Controlled Aliasing in Parallel Imaging Results in Higher Acceleration (CAIPIRINHA) for Multi-Slice Imaging", Magnetic Resonance in Medicine 53, 2005, S. 684-691 beschrieben ist, und die blipped CAIPIRINHA-Technik, wie sie von Setsompop et al. in "Blipped-Controlled Aliasing in Parallel Imaging for Simultaneous Multislice Echo Planar Imaging With Reduced g-Factor Penalty", Magnetic Resonance in Medicine 67, 2012, S. 1210-1224, beschrieben wird.

Insbesondere bei den letztgenannten Schichtmultiplexing-Verfahren wird häufig ein sogenannter Multi-Band-RF-Puls verwendet, um zwei oder mehr Schichten gleichzeitig anzuregen oder anderweitig zu manipulieren, z.B. zu refokussieren oder zu sättigen. Ein solcher Multi-Band-RF-Puls ist dabei z.B. ein Multiplex von individuellen RF-Pulsen, die zur Manipulation der einzelnen gleichzeitig zu manipulierenden Schichten verwendet werden würden. Durch das Multiplexing erhält man z.B. einen grundbandmodulierten Multi-Band-RF-Puls aus einer Addition der Pulsformen der individuellen RF-Pulse. Die Ortskodierung der aufgenommenen Signale wird dabei im Wesentlichen durch eine gängige Gradientenschaltung in zwei Richtungen (zweidimensionale Gradientenkodierung) erreicht. Es ist jedoch auch möglich die anzuregenden Schichten, aus denen Echosignale simultan, mit in einer Aufnahme von Messdaten, aufgenommen werden, jeweils mit einzelnen, z.B. sukzessive geschalteten RF-Pulsen, anzuregen und zu manipulieren. Auch eine kombinierte Verwendung von "Einzelschicht"-RF-Pulsen und Multi-Band-RF-Pulsen ist möglich.

Die entstehenden Signale werden aus allen angeregten Schichten kollabiert in einem Datensatz mittels mehrerer Empfangsantennen aufgenommen und dann mit Hilfe von parallelen Akquisitionstechniken nach den einzelnen Schichten getrennt.

Zu den genannten parallelen Akquisitionstechniken (ppa-Techniken), mit deren Hilfe sich bereits generell zur Aufnahme der gewünschten Daten benötigte Akquisitionszeiten durch eine gemäß Nyquist nicht vollständige, d.h. eine Unterabtastung des k-Raums verkürzen lassen, zählen z.B. GRAPPA ("GeneRalized Autocalibrating Partially Parallel Acquisition") und SENSE ("SENSitivity Encoding"). Die im Rahmen der Unterabtastung nicht-gemessenen Messpunkte im k-Raum sind bei parallelen Akquisitionstechniken in der Regel gleichmäßig über den gemäß Nyquist zu messenden k-Raum verteilt, sodass z.B. jede zweite k-Raumzeile gemessen wird. Darüber hinaus werden die "fehlenden" k-Raumdaten bei parallelen Akquisitionstechniken mit Hilfe von Spulensensitivitätsdaten rekonstruiert. Diese Spulensensitivitätsdaten der bei der Aufnahme der Messdaten verwendeten Empfangsspulen werden aus Referenzmessdaten ermittelt, die zumindest einen Bereich des zu messenden k-Raums, meist den zentralen Bereich, vollständig gemäß der Nyquist-Bedingung abtasten.

Bei Schichtmultiplexing-Verfahren werden parallele Akquisitionstechniken verwendet, um die gleichzeitig für verschiedene Schichten aufgenommenen Messdaten wieder zu trennen. Dabei müssen Referenzmessdaten für alle betroffenen Schichten aufgenommen werden. Dies geschieht in der Regel im Rahmen einer zusätzlich durchzuführenden Referenzmessung, die Referenzmessdaten einzeln für jede gewünschte Schicht misst.

Um die resultierenden Signale der verschiedenen Schichten trennen zu können, wird beispielsweise den individuellen RF-Pulsen vor dem Multiplexing, z.B. durch Addieren einer Phase, die linear (z.B. mit der k-Raumkoordinate in die Phasenkodierrichtung ($k_y$)) steigt, je eine unterschiedliche Phase aufgeprägt. Damit kann jeder Schicht ein unterschiedlicher Phasenanstieg aufgeprägt werden, wodurch die Schichten im Bildraum gegeneinander verschoben werden. Diese Verschiebung wird durch den sogenannten Bildbereich-Verschiebungsfaktor ("FOV (field of view) shift factor" oder "interslice FOV shift") kontrolliert. Wie ein optimaler FOV shift factor bestimmt werden kann, wird beispielsweise in der nachveröffentlichten DE102016218955 beschrieben.

In den genannten Artikel von Breuer et al. und Setsompop et al. beschriebenen CAIPIRINHA-Verfahren werden durch Schalten von zusätzlichen Gradientenblips oder durch zusätzliches Modulieren der Phasen der RF-Pulse (der Multi-Band-RF-Pulse) zwischen den gleichzeitig angeregten Schichten wechselnde Phasenverschiebungen aufgeprägt, die die oben genannten Verschiebungen im Bildraum erzeugen. Diese zusätzlichen Verschiebungen im Bildraum verbessern die Qualität der Trennung der Signale der Schichten, insbesondere, wenn die Spulensensitivitäten derartig geringe Unterschiede in den Sensitivitätsprofilen der einzelnen verwendeten Spulen aufweisen, dass diese nicht für eine zuverlässige Trennung der Schichten ausreichen. Somit werden Artefakte in den letztendlich aus den gemessenen Messdaten rekonstruierten Bilddaten verringert.

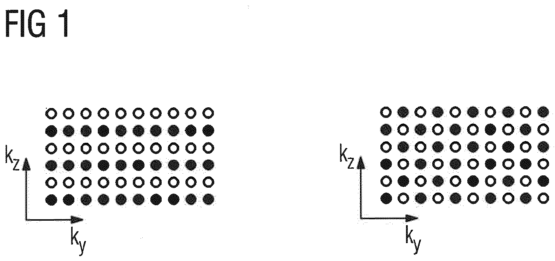

In Figur 1 sind beispielhaft verschiedenen Abtastschemata des k-Raums für GRAPPA-artige parallele Bildgebungstechniken, jeweils mit Beschleunigungsfaktor 2 und einem dreidimensionalen (3D) kartesischen Abtastschema, das jeweils k-Raumlinien in der ky-kx-Ebene abtastet, gegenübergestellt. Die kx-Richtung, in der die dargestellten k-Raumlinien im Beispiel verlaufen, liegt hierbei senkrecht zur Blattebene und das Abtastschema ist in kx-Richtung immer gleich. Die gefüllten Kreise repräsentieren gemessene k-Raumpunkte, die leeren Kreise ausgelassene k-Raumpunkte. Das linke Abtastschema zeigt eine herkömmliche GRAPPA-Abtastung, in der jede zweite k-Raumlinie in einer Raumrichtung (hier: kz-Richtung) ausgelassen wird, und somit nur die Hälfte der k-Raumpunkte gemessen werden.

Die Wirkung der zusätzlichen Phasenverschiebungen auf das Abtastschema einer zweidimensionalen (2D) Schicht-Multiplexing-Messung kann so beschrieben werden (siehe Figur 1 rechts): Durch die zusätzlichen Phasen, die in Schicht-Multiplexing CAIPIRNHA-Verfahren aufgeprägt werden, werden die mit der zusätzlichen Phase beaufschlagten Messpunkte durch eine Verschiebung im k-Raum in kz-Richtung verschoben. Wie groß diese Verschiebung in kz-Richtung ausfällt, hängt von der aufgeprägten Phase ab. Dies ist beispielsweise auch in dem Artikel von Zahneisen et al.: "Three-Dimensional Fourier Encoding of Simultaneously Excited Slices: Generalized Acquisition and Reconstruction Framework", Magn. Reson. Med. 71, S. 2071-2081 (2014), beschrieben.

Die Referenzmessdaten, aus denen Sensitivitätsdaten zur Trennung der gleichzeitig aufgenommenen Schichten und/oder zur Ergänzung fehlender Messdaten gewonnen werden, müssen bisher für jede SMS-Messung zusätzlich gemessen werden. Die zusätzliche Aufnahme der Referenzmessdaten erhöht die insgesamt benötigte Aufnahmezeit und die SAR-Belastung (SAR: "Spezifische AbsorptionsRate") bei Verwendung eines Schicht-Multiplexing-Verfahrens und reduziert somit die eigentlich bei diesen Verfahren angestrebten Vorteile einer gegenüber Einzelschicht-Verfahren reduzierten Messzeit und SAR-Belastung.

Weiterhin können Abweichungen in den bei der Aufnahme der Referenzmessdaten verwendeten Messparametern von den bei der Schicht-Multiplexing-Messung verwendeten Messparametern, insbesondere Messparameter bezüglich der Eigenschaften der RF-Anregungspulse und/oder bezüglich des Auslesevorgangs, wie z.B. die Auslesebandbreite, die Qualität der Trennung der Schichten beeinflussen und zu ungewünschten Artefakten führen. Unter diesem Gesichtspunkt sind in der nachveröffentlichten US-Patentanmeldung 15/262,233 bereits verschiedene Verfahren beschrieben, auf welche Weise derartige Referenzmessdaten neben den Schicht-Multiplexing-Messdaten gewonnen werden können, wobei die Referenzmessdaten immer noch zusätzlich zu dem Messdaten aufgenommen werden müssen.

Um die Trennung der kollabiert aufgenommenen Messdaten der mehreren Schichten in Messdaten der einzelnen Schichten möglichst störungsfrei durchführen zu können, sollten die Aufnahmen der Referenzmessdaten der einzelnen Schichten mit derselben Schichtposition und Schichtorientierung aufgenommen werden wie die in eine Schicht-Multiplexing-Messung gleichzeitig aufgenommenen Messdaten. Verändert sich im Laufe einer MR-Messung die Position oder die Lage einer aufzunehmenden Schicht, beispielsweise durch eine (ungewollte) Bewegung des Untersuchungsobjekts, insbesondere bei länger andauernden MR-Messungen, oder auch durch eine gewollte/bewusste Änderung durch einen Nutzer, so müssen für die geänderte Lage und/oder Position erneut Referenzmessdaten für die weiterhin aufzunehmenden Schichten aufgenommen werden, um weiterhin eine ordnungsgemäße Trennung der Schichten gewährleisten zu können. Länger andauernde MR-Messungen können insbesondere MR-Messungen sein, bei denen eine Zeitserie von MR-Bildern erstellt wird, um den zeitlichen Verlauf beispielsweise eines dargestellten Parameters untersuchen zu können, wie es z.B. bei EPI-BOLD-Messungen oder Diffusionsmessungen der Fall ist.

Bewusste Änderungen von Lage oder Position aufgenommener Schichten sind insbesondere im Rahmen von MR-geführten Interventionen, bei denen z.B. der Weg einer medizinischen Vorrichtung, wie etwa eines Katheters, in dem untersuchten Untersuchungsobjekt nachverfolgt wird, oder auch bei einer Verfolgung von Embolisationen oder einer Überwachung von HIFU("higly focused ultrasound")-Verfahren gewünscht.

Eine erneute Aufnahme von Referenzmessdaten ist jedoch nicht immer möglich und bringt in jedem Fall die bereits oben genannten Nachteile (Verlängerung der insgesamten Messzeit / SAR-Belastung) mit sich. Wird auf eine erneute Aufnahme von Referenzmessdaten verzichtet, verschlechtert sich die Qualität der Trennung der Messdaten der einzelnen Schichten, was zu Artefakten in den letztendlich erhaltenen MR-Daten, beispielsweise Bilddaten, führt. Aus diesen Gründen finden Schicht-Multiplexing-Verfahren bei MR-Messungen, mit welchen Zeitserien erstellt oder bei welchen Änderungen der Position und/oder Lage der aufzunehmenden Schichten erwartet werden, kaum Anwendung.

Für Einzelschicht-ppa-Verfahren ist beispielsweise aus dem Artikel "Dynamic Autocalibrated Parallel Imaging Using Temporal GRAPPA (TGRAPPA)", Magnetic Resonance in Medicine 53, 2005, S. 981-985 von Breuer et al. beschrieben, wie Kalibrierungsdaten im Verlauf mehrerer ppa-Messungen aktualisiert werden können. Die dort beschriebenen Verfahren beschränken sich jedoch auf die Variation von k-Raumlinien in Phasenkodierrichtung (meist $k_y$-Richtung) für eine zweidimensionale GRAPPA-Rekonstruktion und lassen sich somit nicht auf Schicht-Multiplexing-Verfahren anwenden.

In der nachveröffentlichten DE102017201477 ist bereits ein Verfahren beschrieben, dass eine Bewegung des Untersuchungsobjekts detektiert und unter Berücksichtigung der bestimmten Bewegung eine Neuberechnung von für die Schichttrennung und/oder die Ergänzung von Schichtmessdaten verwendeten lokalen Gewichtungsmatrizen vornimmt. Dazu müssen jedoch die für die Gewichtungsmatrix aufzunehmenden Referenzdaten ein größeres Volumen abdecken als ohne eine derartige Neuberechnung nötig wäre. Darüber hinaus verlangt die Neuberechnung komplexe Rechenschritte und ist daher nicht leicht zu implementieren.

In dem Konferenzbeitrag von Zhu K. et al., "Simultaneous Multislice Flyback Echo Planar Imaging with Auto-calibraton", Proceedings of the ISMRM, 07.04.2013, wird ein Blipped-CAIPI-Verfahren vorgestellt, bei dem die Notwendigkeit externer Kalibrationsscans dadurch umgangen wird, dass vollständig abgetastete Autokalibrationssignale in einem zentralen k-RaumBereich aufgenommen werden.

Der Erfindung liegt daher die Aufgabe zugrunde, mittels Schicht-Multiplexing-Verfahren beschleunigte Aufnahmen von MR-Daten auch für MR-Messungen, bei welchen im Laufe der MR-Messung mindestens eine Änderung der Messbedingungen, z.B. der Position und/oder Lage der aufzunehmenden Schichten, erwartet werden, auf eine leicht zu implementierende Art und Weise zu ermöglichen.

Die Aufgabe wird gelöst durch ein Verfahren zur Erzeugung von Messdaten eines Untersuchungsobjektes mittels Magnetresonanztechnik gemäß Anspruch 1, eine Magnetresonanzanlage gemäß Anspruch 12, ein Computerprogramm gemäß Anspruch 13, sowie einen elektronisch lesbaren Datenträger gemäß Anspruch 14.

Die Referenzmessung kann auch mit einer von der Bildgebungsmessung verschiedenen Aufnahmesequenz aufgenommen werden, vorzugsweise wird aber ein ähnlicher Kontrast verwendet.

Ein erfindungsgemäßes Verfahren zur Erzeugung von Messdaten eines Untersuchungsobjektes mittels Magnetresonanztechnik umfasst die Schritte:

a) Wiederholtes Einstrahlen mindestens eines RF-Anregungspulses, wobei die eingestrahlten RF-Anregungspulse mindestens zwei sich nicht überschneidende Schichten in dem Untersuchungsobjekt selektiv anregen, und Schalten von Gradienten derart, dass durch die geschalteten Gradienten und die eingestrahlten RF-Anregungspulse Echosignale in den mindestens zwei Schichten erzeugt werden, und derart dass die erzeugten Echosignale als Messdaten in je einem Messdatensatz pro Wiederholung gemäß je einem anderen dreidimensional betrachteten Abtastschema pro Wiederholung im k-Raum aufgenommen und gespeichert werden, wobei jedes angewandte Abtastschema zwar gemäß Nyquist unterabgetastet ist, und wobei aber eine Kombination der in den Wiederholungen angewandten Abtastschemata zumindest in einem zentralen Bereich den k-Raum vollständig abtastet,
b) Bestimmen von Kalibrierungsdaten aus Messdaten der gespeicherten Messdatensätze aus dem vollständig abgetasteten zentralen Bereich des k-Raums,
c) Rekonstruieren von Bilddaten jeder der Schichten aus zumindest einem der gespeicherten Messdatensätze unter Verwendung der Kalibrierungsdaten,
d) Wiederholen der Schritte a) und c), wobei zumindest einmal aktuelle Kalibrierungsdaten aus aktuellen Messdaten bestimmt werden, die für die Rekonstruktion von Bilddaten der Schichten aus aktuellen Messdatensätzen verwendet werden.

Wie in dem bereits genannten Artikel von Zahneisen et al. weiter beschrieben ist, führt eine Wahl der gewünschten Verschiebung im Bildraum um ein Vielfaches den N-ten Teils des Bildbereichs FOV (bei N gleichzeitig angeregten Schichten) zu einer Verschiebung der gemessenen k-Raumpunkte im k-Raum (in die kz-Richtung) um einen Betrag, der einer gemäß Nyquist vollständigen Abtastung in dieser k-Raumrichtung entspricht. Damit kann eine 2D Schicht-Multiplexing-Messung analog zu einer 3D CAIPIRIHNA-Messung betrachtet werden.

Der Erfindung liegt nun die Erkenntnis zugrunde, dass eine derartige Betrachtung als 3D Messung, und damit eine Betrachtung der für Schicht-Multiplexing-Messungen verwendeten Abtastschema ebenfalls als 3D Abtastschema, eine einfach zu implementierende Möglichkeit liefert, verschiedene Abtastschemata zu wählen, die zwar einzeln den k-Raum unterabtasten, die aber in Kombination den k-Raum zumindest in einem zentralen Bereich vollständig abtasten.

Durch die erfindungsgemäße Verwendung derartiger verschiedener dreidimensional betrachteter Abtastschemata ist es möglich, im Laufe der Messung bereits bestimmte Kalibrierungsdaten zu aktualisieren. Von der Aufnahme der Messdaten separate Aufnahmen von Kalibrierungsdaten können ganz entfallen, wodurch Messzeit eingespart wird und die SAR-Belastung niedrig gehalten wird.

Die erfindungsgemäße, einfach zu implementierende Aktualisierung von Kalibrierungsdaten verbessert die Bildqualität der aus den beschleunigt aufgenommenen Messdaten erstellten Bilddaten, denn die für die Rekonstruktion verwendeten Kalibrierungsdaten werden einerseits direkt aus den aufgenommenen Messdaten bestimmt und sind somit inhärent optimal an diese angepasst, andererseits sind durch die Aktualisierung der Kalibrierungsdaten auch jeweils an ggf. geänderte Messbedingungen angepasste Kalibrierungsdaten verfügbar, wodurch sowohl die Trennung der gleichzeitig aufgenommenen Messdaten in Einzelschichtmessdaten als auch eine ggf. gewünschte Ergänzung von beschleunigt aufgenommenen Einzelschichtmessdaten, auch nach Änderungen der Messbedingungen in gleichbleibend guter Qualität ermöglicht werden.

Durch die erfindungsgemäße Aktualisierung der Kalibrierungsdaten werden Schicht-Multiplexing-Verfahren auch für MR-Messungen sinnvoll einsetzbar, bei welchen sich im Laufe der MR-Messung Änderungen der Messbedingungen ergeben, da erfindungsgemäß aktualisierte Kalibrierungsdaten derartigen Änderungen Rechnung tragen. Damit können insbesondere auch Interventionsüberwachungen(, welche eine Echtzeit-Wiedergabe der aufgenommenen Bilddaten erfordern,) mit Schicht-Multiplexing-Verfahren, und damit z.B. mit besserer Auflösung und/oder kürzerer Messzeit pro Bild und trotzdem hoher Bildqualität, durchgeführt werden.

Auch z.B. in Diffusionsverfahren, bei welchen MR-Messungen mit verschiedenen b-Werten und/oder in verschiedenen Diffusionsrichtungen durchgeführt werden, erlauben erfindungsgemäß bestimmte Kalibrierungsdaten eine von den geänderten Messbedingungen (b-Werte / Diffusionsrichtungen) unabhängig gute Bildqualität und reduzieren oder verhindern sogar Bildverzerrungen, welche ansonsten oftmals durch Wirbelströme verursacht werden, die durch die Änderungen in den Messbedingungen entstehen können.

Die verschiedenen angewandten Abtastschemata können hierbei jeweils eine gleichartige Unterabtastung und eine gleiche aufgeprägte Verschiebung im Bildraum in Schichtrichtung aufweisen, was die Implementierung weiter erleichtert.

Besonders einfach sind erfindungsgemäße Abtastschemata durch eine Permutation eines Start-Abtastschemas auffindbar. Die verschiedenen angewandten Abtastschemata unterscheiden sich somit durch eine, insbesondere zyklische, Permutation voneinander. Hierbei können insbesondere die Positionen der Messpunkte im k-Raum permutiert werden, welche Messpunkte mit einer zusätzlichen Phase beaufschlagt werden, um eine Verschiebung im Bildraum in Schichtrichtung aufzuprägen.

Eine erfindungsgemäße Magnetresonanzanlage umfasst eine Magneteinheit, eine Gradienteneinheit, eine Hochfrequenzeinheit und eine zur Durchführung eines erfindungsgemäßen Verfahrens ausgebildete Steuereinrichtung mit einer Hochfrequenz-Sende-/Empfangs-Steuerung und eine Phasenbestimmungseinheit.

Ein erfindungsgemäßes Computerprogramm implementiert ein erfindungsgemäßes Verfahren auf einer Steuereinrichtung, wenn es auf der Steuereinrichtung ausgeführt wird.

Das Computerprogramm kann hierbei auch in Form eines Computerprogrammprodukts vorliegen, welches direkt in einen Speicher einer Steuereinrichtung ladbar ist, mit Programmcode-Mitteln, um ein erfindungsgemäßes Verfahren auszuführen, wenn das Computerprogrammprodukt in der Recheneinheit des Rechensystems ausgeführt wird.

Ein erfindungsgemäßer elektronisch lesbarer Datenträger umfasst darauf gespeicherte elektronisch lesbare Steuerinformationen, welche zumindest ein erfindungsgemäßes Computerprogramm umfassen und derart ausgestaltet sind, dass sie bei Verwendung des Datenträgers in einer Steuereinrichtung einer Magnetresonanzanlage ein erfindungsgemäßes Verfahren durchführen.

Die in Bezug auf das Verfahren angegebenen Vorteile und Ausführungen gelten analog auch für die Magnetresonanzanlage, das Computerprogrammprodukt und den elektronisch lesbaren Datenträger.

Weitere Vorteile und Einzelheiten der vorliegenden Erfindung ergeben sich aus den im Folgenden beschriebenen Ausführungsbeispielen sowie anhand der Zeichnungen. Die aufgeführten Beispiele stellen keine Beschränkung der Erfindung dar. Es zeigen:

Fig. 1 eine schematische Gegenüberstellung verschiedener Abtastschemata des k-Raums für parallele Akquisitionstechniken,

Fig. 2 ein schematisches Ablaufdiagramm eines erfindungsgemäßen Verfahrens,

Fig. 3    eine schematische Darstellung eines einfachen Beispiels erfindungsgemäßer verschiedener Abtastschemata,

Fig. 4    eine schematische Darstellung eines weiteren Beispiels erfindungsgemäßer verschiedener Abtastschemata,

Fig. 5    eine schematische Darstellung einer erfindungsgemäßen Magnetresonanzanlage.

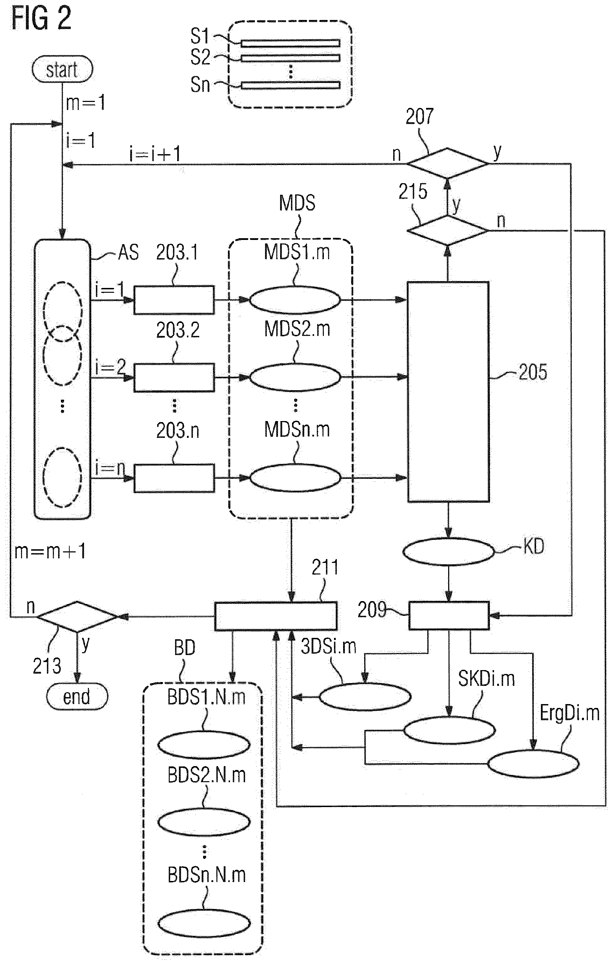

Figur 2 ist ein schematisches Ablaufdiagramm eines erfindungsgemäßen Verfahrens zur Erzeugung von Messdaten eines Untersuchungsobjektes mittels Magnetresonanztechnik.

Nach dem Start ("start") eines erfindungsgemäßen Verfahrens können zunächst mindestens zwei dreidimensional betrachtet verschiedene Abtastschemata AS bestimmt werden, gemäß derer Messdaten von N sich nicht überschneidenden Schichten aufgenommen werden sollen. Unter einer dreidimensionalen Betrachtung wird hierbei eine Betrachtung der Abtastschemata in einem dreidimensionalen k-Raum, d.h. in allen drei k-Raumrichtungen, verstanden, die die k-Raumpositionen festlegen, an welchen Messpunkte liegen. Jedes der Abtastschemata AS ist zumindest in der dreidimensionalen Betrachtung gemäß Nyquist unterabgetastet. Die Abtastschemata AS sind jedoch so gewählt, dass sie Messpunkte im k-Raum derart festlegen, dass eine Kombination der in den n Abtastschemata jeweils abgetasteten Messpunkten im k-Raum den k-Raum zumindest in einem gewünschten zentralen Bereich vollständig abtasten.

Die gesuchten verschiedenen anzuwendenden Abtastschemata AS können hierbei durch Permutation bestimmter Merkmale eines Startabtastschemas gewonnen werden, wodurch sich die verschiedenen anzuwendenden Abtastschemata AS voneinander durch diese Permutation voneinander unterscheiden. Hierbei kann insbesondere ein Startabtastschema gemäß mit zusätzlichen Phasen belegten k-Raumpositionen permutiert werden, wodurch auf besonders einfache Weise geeignete Abtastschemata erstellt werden können, die darüber hinaus jeweils eine gleichartige Unterabtastung und aufgeprägte Verschiebung im Bildraum in Schichtrichtung aufweisen. Eine Wahl der verschiedenen anzuwendenden Abtastschemata AS derart, dass diese jeweils eine gleichartige Unterabtastung (Beschleunigung sowohl durch kollabierte Aufnahme von Messdaten mehrerer Schichten als auch innerhalb der Schichten) und aufgeprägte Verschiebung der Schichten im Bildraum (interslice FOV shift) aufweisen, macht die letztendlich rekonstruierten Bilddaten besser vergleichbar.

Es werden N Schichten eines Untersuchungsobjekts durch Einstrahlen mindestens eines RF-Anregungspulses und durch Schalten von Gradienten selektiv anregt, sodass Echosignale in den N Schichten erzeugt werden. Bei den eingestrahlten RF-Anregungspulsen kann es sich um mindestens einen Multi-Band-RF-Anregungspuls oder um RF-Anregungspulse, welche jeweils eine Schicht der N Schichten anregen, oder um eine Kombination aus mindestens einem Multi-Band-RF-Anregungspuls und RF-Anregungspulsen, welche jeweils eine Schicht der N Schichten anregen, handeln.

Die eingestrahlten RF-Anregungspulse und geschalteten Gradienten nehmen die erzeugten Echosignale gemäß einem ersten Abtastschema AS i=1 als Messdaten, die in einem Messdatensatz MDS1.m gespeichert werden (Block 203.1). Aus Messdaten der gespeicherten Messdaten MDS werden Kalibrierungsdaten KD bestimmt (Block 205). Dazu werden zumindest die in einem gewünschten zentralen Bereich des k-Raums liegenden Messdaten der Messdatensätze MDS gesammelt. Liegen in dem zentralen Bereich des k-Raums noch keine vollständigen Messdaten vor, und wurden also noch nicht gemäß aller vorgesehener Abtastschemata AS Messdatensätze MDS aufgenommen (Abfrage 207, n) wird die Aufnahme eines neuen Messdatensatzes MDS der N Schichten gemäß einem noch nicht durchgeführten Abtastschema i=i+1 wiederholt. Gegebenenfalls wird die Abfrage 207 nach jedem Erfülltsein einer Triggerbedingung wiederholt (siehe Abfrage 215 weiter unten). Die Aufnahme von Messdatensätzen MDS der N Schichten wird insgesamt n (n>1) Mal durchgeführt, wobei bei jeder Wiederholung i RF-Anregungspulse derart eingestrahlt und Gradienten derart geschaltet werden, dass sich jeweils ein anderes dreidimensional betrachtetes Abtastschema AS ergibt (Blöcke 203.i) und jeweils Messdatensätze MDSi.m (i=l, 2, ..., n) der N Schichten aufgenommen werden.

Wurden bereits Messdatensätze MDS gemäß aller vorgesehener Abtastschemata AS aufgenommen (Abfrage 207, y) und liegen somit in den kombinierten Messdatensätzen MDS in dem zentralen Bereich des k-Raums ein vollständiger Satz an Messdaten vor, aus dem Kalibrierungsdaten KD bestimmt werden konnten, können aus den Kalibrierungsdaten KD, z.B. unter Verwendung von einer 3D parallelen Akquisitionstechnik, dreidimensionale Kalibrierungsdatensätze 3DSi.m erstellt werden, mit welchen die unterabgetastet aufgenommenen Messdatensätze MDSi.m jeweils ergänzt werden können (Block 209). Es ist auch möglich, dass aus den bestimmten Kalibrierungsdaten KD, z.B. unter Verwendung von einer für die Trennung von kollabiert aufgenommenen Messdaten mehrerer Schichten bekannten parallelen Akquisitionstechnik, Schichttrennungsdaten SKDi.m zur Trennung der in den in den Messdatensätzen MDSi.m aufgenommenen Messdaten enthaltenen Signale aller N Schichten in Schichtmessdatensätze SMDSi.N.m (nicht dargestellt) der jeweiligen einzelnen Schichten bestimmt werden (Block 209). Sind die bestimmten Schichtmessdatensätze SMDSi.N.m der jeweiligen einzelnen Schichten selbst unterabgetastet, können weiterhin, z.B. unter Verwendung von einer 2D parallelen Akquisitionstechnik, aus den bestimmten Kalibrierungsdaten KD Ergänzungsdaten ErgDi.m zur Ergänzung der Schichtmessdatensätze SMDSi.N.m zu vollständigen Schichtmessdatensätzen SMDSi.N.m' (nicht dargestellt) bestimmt werden (Block 209).

Unter Verwendung der Kalibrierungsdaten KD werden Bilddaten BD jeder der N Schichten von zumindest einem der gespeicherten Messdatensätze MDSi.m rekonstruiert, sodass zu jedem gewünschten Messdatensatz MDSi.m N Bilddatensätze BDSi.N.m rekonstruiert werden (Block 211).

Wurden aus den Kalibrierungsdaten KD dreidimensionale Kalibrierungsdatensätze 3DSi.m erstellt, können hierbei die gewünschten Messdatensätze MDSi.m mit Hilfe des zugehörigen dreidimensionalen Kalibrierungsdatensatzes 3DSi.m zu vollständigen dreidimensionalen Messdatensätzen MDSi.m' (nicht dargestellt) ergänzt werden, und die zugehörigen Bilddatensätze BDSi.N.m z.B. durch eine dreidimensionale Fouriertransformation aus den ergänzten Messdatensätzen MDSi.m' rekonstruiert werden können.

Wurden aus den Kalibrierungsdaten KD Schichttrennungsdaten SKDi.m zur Trennung der in den in den Messdatensätzen MDSi.m aufgenommenen Messdaten enthaltenen Signale aller N Schichten in Schichtmessdatensätze SMDSi.N.m der einzelnen Schichten bestimmt, können zunächst die Schichtmessdatensätze SMDSi.N.m erstellt werden, aus welchen dann jeweils, z.B. mittels einer 2D Fouriertransformation, die zugehörigen Bilddatensätze BDSi.N.m rekonstruiert werden können.

Sind bestimmte Schichtmessdatensätze SMDSi.N.m selbst unterabgetastet, und wurden weiterhin Ergänzungsdaten ErgDi.m zur Ergänzung der Schichtmessdatensätze SMDSi.N.m zu vollständigen Schichtmessdatensätzen SMDSi.N.m' bestimmt, können die unterabgetasteten Schichtmessdatensätze SMDSi.N.m zunächst, z.B. gemäß einer passenden parallelen Akquisitionstechnik, unter Verwendung der jeweiligen Ergänzungsdaten ErgDi.m zu vollständigen Schichtmessdatensätzen SMDSi.N.m' ergänzt werden, aus welchen dann jeweils, z.B. mittels einer 2D Fouriertransformation, die zugehörigen Bilddatensätze BDSi.N.m rekonstruiert werden können.

Sind somit bereits alle gewünschten Bilddaten BD erstellt (Abfrage 213, y), endet das Verfahren ("end").

Sind noch nicht alle gewünschten Bilddaten BD rekonstruiert worden (Abfrage 213, n), mindestens jedoch einmal, wird die Aufnahme von Messdaten MDSi.m gemäß den gewünschten Abtastschemata AS (Blöcke 203.i) und die Rekonstruktion der Bilddaten BD (Block 211) für mindestens ein Abtastschema wiederholt. Somit werden mindestens zwei Bilddatensätze BDSi.N.1 und BDSi.N.2 zu mindestens zwei zeitlich beabstandet durchgeführten Wiederholungen m=1 und m=2 für eine der N Schichten und eine der n Wiederholungen der Aufnahme von Messdaten mit Abtastschema i erstellt.

Dabei können stets (Abfrage 215 (obsolet) immer erfüllt, y), insbesondere nach jeder erfolgten Aufnahme von Messdatensätzen MDSi.m, aktuelle Kalibrierungsdaten KD aus aktuellen Messdaten der Messdatensätze MDSi.m bestimmt werden, die für die Rekonstruktion von Bilddaten der Schichten aus aktuellen Messdatensätzen verwendet werden. Beispielsweise können jeweils in einer aktuellen, letzten Aufnahme von Messdaten 203.i aufgenommene Messdaten direkt für dieselbe k-Raumposition in einer älteren Aufnahme von Messdaten aufgenommene Messdaten in den Kalibrierungsdaten KD ersetzen, sodass die Kalibrierungsdaten KD mit jeder erneuten Aufnahme von Messdaten 203.i an den entsprechenden k-Raumpositionen aktualisiert werden können. Aus den auf diese Weise aktualisierten Kalibrierungsdaten KD können aktualisierte dreidimensionale Kalibrierungsdatensätze 3DSi.m erstellt und/oder aktualisierte Schichttrennungsdaten SKDi.m und/oder aktualisierte Ergänzungsdaten ErgDi.m bestimmt werden (siehe Block 209).

Stets aktualisierte Kalibrierungsdaten KD gewährleisten auch stets für die Rekonstruktion von Bilddaten BD optimal zu den aufgenommenen Messdatensätzen MDSi.m angepasste Kalibrierungsdaten KD und damit optimale Rekonstruktionsergebnisse.

Es ist jedoch auch möglich, dass bei Erfülltsein einer Triggerbedingung (Abfrage 215, y) aktuelle Kalibrierungsdaten bestimmt werden, bei Nicht-Erfülltsein der Triggerbedingung (Abfrage 215, n) können bereits vorhandene Kalibrierungsdaten KD für die Rekonstruktion der Bilddaten BD aus Messdatensätzen MDSi.m (m>1)(Block 211) verwendet werden. Die Triggerbedingung ist hierbei auf jeden Fall erfüllt, solange noch kein vollständiger Satz an Kalibrierungsdaten KD bestimmt wurde.

Bei einer Aktualisierung der Kalibrierungsdaten KD nur bei Erfülltsein einer Triggerbedingung wird der Rechenaufwand niedrig gehalten und nur bei Bedarf eine Anpassung der Kalibrierungsdaten und damit angepassten Rekonstruktion von Bilddaten BD durchgeführt.

Dabei kann die Triggerbedingung erfüllt sein, sobald sich eine Messbedingung durch eine Nutzereingabe ändert, beispielsweise, wenn ein Nutzer Bildgebungsparameter (z.B. die Schichtorientierung) der Messung ändert. Somit wird sichergestellt, dass aktuelle, den geänderten Messbedingungen angepasste Kalibrierungsdaten erstellt werden.

Zusätzlich oder alternativ kann (unabhängig von der Art der aufgenommenen Messdaten) eine Bewegung des Untersuchungsobjekts oder auch eines in dem Untersuchungsobjekt befindlichen Körpers, wie z.B. einem Katheter, detektiert werden, und die Triggerbedingung erfüllt sein, wenn die detektierte Bewegung einen vorgegebenen Schwellwert überschreitet. Die Detektion der Bewegung des Untersuchungsobjekts kann hierbei über externe, beispielsweise auch physikalische, Sensoren oder auch mittels MR-Navigatormessungen auf bekannte Art und Weise erfolgen. Durch eine derartige Überwachung der Bewegung des Untersuchungsobjekts kann automatisch eine Aktualisierung der Kalibrierungsdaten bei einer über dem Schwellwert liegenden Bewegung veranlasst werden, wodurch auch im Falle von Änderungen von Lage und/oder Position der gemessenen Schichten eine hohe Bildqualität der mit Hilfe der aktualisierten Kalibrierungsdaten rekonstruierten Bilddaten gewährleistet werden kann.

Ebenso zusätzlich oder alternativ kann die Triggerbedingung erfüllt sein, sobald sich die Messbedingungen durch (z.B. messungsbedingte) Änderungen in der zur Messung verwendeten Hardware verändern. Beispielsweise, wenn die Temperatur z.B. der Gradientenspule um mehr als einen vorgegebenen Schwellwert, z.B. um mehr als 10 Grad während der Messung, ansteigt. Eine derartige Änderung der Hardware-Bedingungen kann beispielsweise mittels externer Sensoren detektiert werden, welche die Triggerbedingung auslösen können.

Allgemein kann die Triggerbedingung erfüllt sein, wenn sich Messbedingungen, insbesondere in einem über einen vorgegebenen Schwellwert hinausgehenden Maß, verändern. Dazu können Änderungen von Messbedingungen, insbesondere durch eine Bewegung des Untersuchungsobjekts oder messbedingt durch eine Änderung von Hardwarebedingungen der für die Messung verwendeten Magnetresonanzanlage während der Messung, detektiert werden.

Sind die aufgenommenen Messdaten MDS1.m Diffusionsmessdaten für Diffusionsmessungen an dem Untersuchungsobjekt, kann als Triggerbedingung eine Änderung des b-Werts herangezogen werden, beispielsweise sodass durch die im Messablauf vorgegebenen Änderungen des b-Werts, die Triggerbedingung jeweils automatisch erfüllt ist, wenn der b-Wert geändert wurde. Somit werden für jeden gemessenen b-Wert jeweils angepasste Kalibrierungsdaten bestimmt. Durch die Änderung der b-Werte werden die Messbedingungen geändert, wodurch Bildverzerrungen und Artefakte, beispielsweise durch geänderte Wirbelströme, auftreten können. Durch die Aktualisierung der Kalibrierungsdaten KD für jeden b-Wert können Auswirkungen derartiger Verzerrungen und Artefakte reduziert oder sogar verhindert werden.

Zusätzlich oder alternativ kann, bei einer Aufnahme von Diffusionsmessdaten als Triggerbedingung eine Änderung der gemessenen Diffusionsrichtung genutzt werden, beispielsweise sodass die Triggerbedingung (auch) dann automatisch erfüllt ist, wenn eine Richtung geändert wird, in welche die Diffusionswerte gemessen werden, und somit eine Diffusionsgradientenorientierung geändert wird. Auch eine solche Richtungsänderung ist in der Regel in dem Messablauf vorgegeben und kann somit ohne Schwierigkeiten als Triggerbedingung dienen. Somit werden für jede gemessene Diffusionsrichtung jeweils angepasste Kalibrierungsdaten bestimmt. Durch die Änderung der Diffusionsrichtung werden wieder die Messbedingungen geändert, wodurch wieder Bildverzerrungen und Artefakte, beispielsweise durch geänderte Wirbelströme, auftreten können. Durch die Aktualisierung der Kalibrierungsdaten KD für jede Diffusionsrichtung können Auswirkungen derartiger Verzerrungen und Artefakte reduziert oder sogar verhindert werden.

Zusätzlich oder alternativ kann bei Aufnahme jeglicher Messdaten auch ein manueller Trigger verwendet werden, beispielsweise indem durch eine Eingabe eines Nutzers die Triggerbedingung auf "erfüllt" gesetzt werden kann. So kann die Triggerbedingung durch ein manuelles Triggersignal erfüllt werden. Ein manueller Trigger ermöglicht es einem Nutzer jederzeit, z.B. wenn ein Bedarf beispielsweise durch eine manuelle Änderung der Messbedingungen oder durch Beobachtung der erhaltenen Bilddaten gesehen wird, für die Rekonstruktion der Bilddaten angepasste Kalibrierungsdaten zur Verfügung zu stellen.

Es ist jedoch auch denkbar, die Triggerbedingung jeweils nach einer gewissen Zeitspanne, z.B. 5 Minuten, erfüllt sein zu lassen, sodass regelmäßig aktuelle Kalibrierungsdaten bestimmt werden.

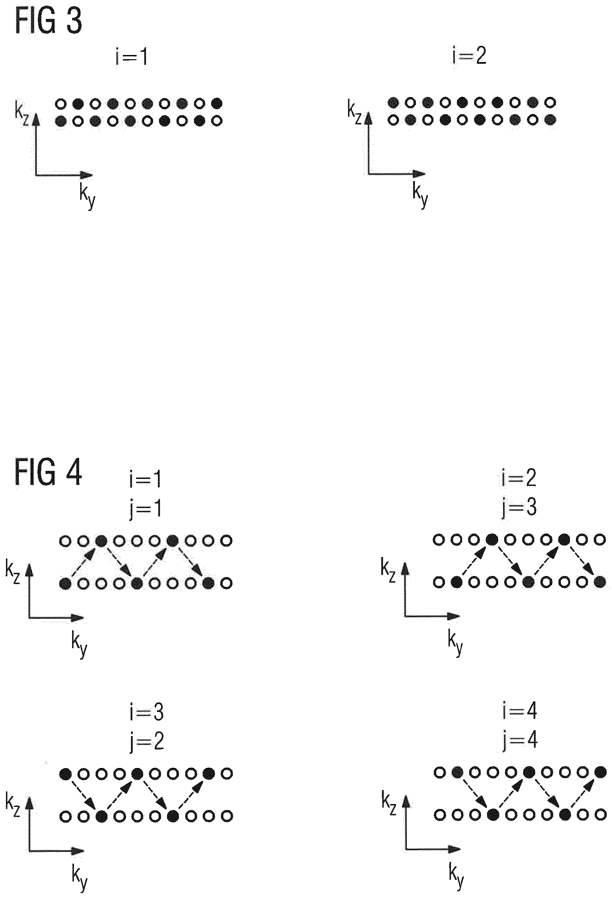

Ein einfaches Beispiel für n=2 verschiedene anzuwendende Abtastschemata ist in Figur 3 veranschaulicht, in der beispielhaft das Prinzip einer k-Raumabtastung mit einem Bildbereich-Verschiebungsfaktor von $\frac{FOV}{2}$ für eine erste Aufnahme (i=I) mit dem links dargestellten Abtastschema und eine Wiederholung der Aufnahme (i=2) mit dem rechts dargestellten Abtastschema gezeigt ist. Dabei liegt, wie bereits in Figur 1, die $k_x$-Richtung senkrecht zur Blattebene. Somit ist in Figur 3 ein kartesisches Abtastschema dargestellt. Das Verfahren kann analog auch bei nicht-kartesischen Abtastschemata, z.B. radialen oder spiralen Abtastschemata, angewandt werden.

In Figur 3 sind analog zu Figur 1 aufgenommene k-Raumpunkte als schwarz gefüllte Kreise dargestellt wohingegen nicht aufgenommene k-Raumpunkte als weiß gefüllte Kreise dargestellt sind. In der links gezeigten ersten Aufnahme ist in $k_y$-Richtung jeder zweite k-Raumpunkt durch zusätzlich aufgeprägte Phasen $\phi_1$ in $k_z$-Richtung verschoben. Dies kann z.B. durch Anwenden einer CAIPIRINHA-Technik erreicht werden. In der rechts gezeigten Wiederholung sind die zusätzlichen Phasen $\phi_1$ derart geändert, dass wiederum in $k_y$-Richtung jeder zweite k-Raumpunkt durch zusätzlich aufgeprägte Phasen $\phi_2$ in $k_z$-Richtung verschoben ist, jedoch sind in der Wiederholung gerade diejenigen k-Raumpunkte in $k_z$-Richtung verschoben, die in der ersten Aufnahme nicht verschoben waren. In dem gezeigten Beispiel können somit durch einfaches Permutieren der mit zusätzlichen Phasen $\phi_i$ belegten k-Raumpunkte sich in einer dreidimensionalen Betrachtungsweise unterscheidende Abtastschemata gewonnen werden, die kombiniert den k-Raum vollständig abtasten, sodass sowohl für Messdatensätze, die mit dem Abtastschema i=1 aufgenommen wurden, als auch für Messdatensätze, die mit dem Abtastschema i=1 aufgenommen wurden, Kalibrierungsdaten aus den kombinierten Messdaten jeweils zumindest des gewünschten zentralen Bereichs des k-Raums einer Aufnahme mit dem Abtastschema i=1 und einer Aufnahme mit dem Abtastschema i=2 gewonnen werden können.

Für andere Beschleunigungsfaktoren und/oder Bildbereich-Verschiebungsfaktoren kann ein derartiges Permutieren der mit zusätzlichen Phasen beaufschlagten k-Raumpunkte je Abtastschema analog erfolgen, wobei die Anzahl n der für eine, zumindest bereichsweise, vollständige Abtastung nötigen Wiederholungen von den verwendeten Beschleunigungsfaktoren und Bildbereich-Verschiebungsfaktoren abhängt.

Beispielsweise könnte bei einem Bildbereich-Verschiebungsfaktor von $\frac{FOV}{3}$ mit drei Abtastschemata, bei denen die mit zusätzlich aufgeprägten Phasen $\phi_i$ belegten k-Raumpunkte jeweils permutiert werden, in n=3 Wiederholungen der gewünschte k-Raumbereich vollständig abgetastet werden.

Figur 4 ist eine schematische Darstellung eines weiteren Beispiels erfindungsgemäßer verschiedener Abtastschemata i=1, i=2, i=3 und i=4. Die Abtastschemata i=1 bis i=4 entsprechen jeweils Abtastschemata mit Beschleunigungsfaktoren SMS=2 (d.h. kollabierte Aufnahme von Messdaten aus zwei Schichten) und PPA=2 (d.h. innerhalb der Schichten werden nur die Hälfte der gemäß Nyquist erforderlichen Messpunkte gemessen, die andere Hälfte ist mittels paralleler Akquisitionstechniken zu ergänzen), und wurden durch zyklische Permutation der mit zusätzlichen Phasen $\phi_i$ zu beaufschlagenden k-Raumpositionen in ky-Richtung bestimmt.

Analog zu Figur 3 ergibt auch eine Kombination (zumindest in einem gewünschten zentralen Bereich des k-Raums) der gemäß allen der in Figur 4 vier dargestellten Abtastschemata aufgenommenen Messdaten einen (in dem kombinierten Bereich) vollständigen Satz an Messdaten aus dem erfindungsgemäß Kalibrierungsdaten bestimmt werden können.

Sollen aus den Kalibrierungsdaten Schichttrennungsdaten zur Trennung der in aufgenommenen Messdaten kollabiert enthaltenen Signale in Schichtmessdatensätze der jeweiligen einzelnen Schichten bestimmt werden, kann die Reihenfolge, in welcher die verschiedenen Abtastschemata für aufeinanderfolgende Aufnahmen von Messdaten verwendet werden, derart gewählt werden, dass die (zumindest in dem zentralen Bereich des k-Raums) kombinierten Messdaten der gemäß der bestimmten Reihenfolge zuerst aufgenommenen Messdatensätze sich zunächst in Schichtrichtung im k-Raum (hier kz-Richtung) gegenseitig vervollständigen und erst nachranging in anderen Richtungen.

Eine mögliche derartige Reihenfolge für das Beispiel von Figur 4 ist in Figur 4 durch den Index j gegeben. In dieser Reihenfolge der Abtastschemata j=1, j=2, j=3 und j=4 werden bereits mit der zweiten Wiederholung der Aufnahme der Messdaten (mit Abtastschema j=2) diejenigen Messdaten aufgenommen, welche die mit der ersten Aufnahme von Messdaten (mit Abtastschema j=1) aufgenommenen Messdaten in kz-Richtung zu einem vollständigen Satz an Messdaten (in kz-Richtung) ergänzen. Die bei der Wiederholung der Aufnahme der Messdaten mit Abtastschema j=3 aufgenommenen Messdaten werden durch die bei der nächsten Wiederholung der Aufnahme der Messdaten (mit Abtastschema j=4) aufgenommenen Messdaten in kz-Richtung zu einem vollständigen Satz an Messdaten (in kz-Richtung) ergänzt. Damit kann bereits nach nur einem Teil der insgesamt mit verschiedenen Abtastschemata durchzuführenden Wiederholungen (im gezeigten Beispiel jeweils nach nur zwei Wiederholungen), aus den in diesen Wiederholungen aufgenommenen Messdaten Kalibrierungsdaten bestimmt werden, die zumindest in kz-Richtung (Schichtrichtung) vollständig sind, und aus welchen Schichttrennungsdaten bestimmt werden können. Werden nur mit einem SMS-Beschleunigungsfaktor beschleunigt aufgenommene Messdatensätze aufgenommen, kann somit bereits nach nur dem genannten Teil der der insgesamt mit verschiedenen Abtastschemata durchzuführenden Wiederholungen aktualisierte Kalibrierungsdaten bestimmt werden.

Für eine ggf. nötige Erstellung von Ergänzungsdaten (für eine Ergänzung von unvollständigen Schichtmessdatensätzen der einzelnen Schichten) ist jedoch weiterhin zumindest je eine Wiederholung von Aufnahmen von Messdaten für jede der mit verschiedenen Abtastschemata durchzuführenden Wiederholungen für die Bestimmung von auch in den anderen Richtungen vollständigen Kalibrierungsdaten erforderlich.

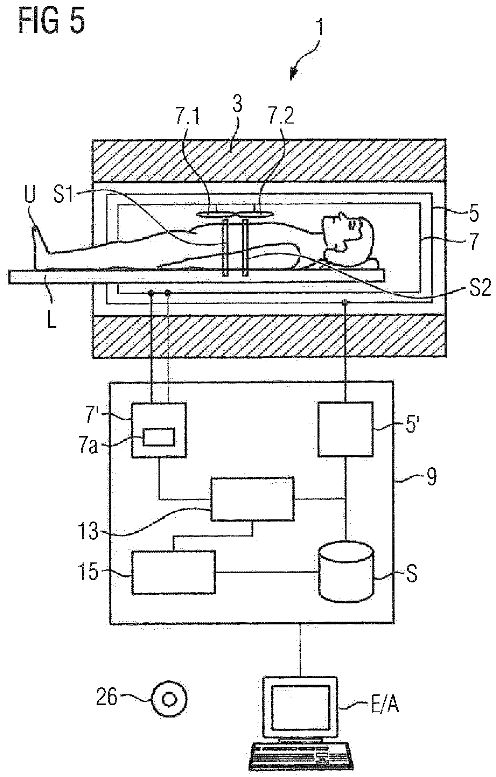

Figur 5 stellt schematisch eine erfindungsgemäße Magnetresonanzanlage 1 dar. Diese umfasst eine Magneteinheit 3 zur Erzeugung des Grundmagnetfeldes, eine Gradienteneinheit 5 zur Erzeugung der Gradientenfelder, eine Hochfrequenzeinheit 7 zur Einstrahlung und zum Empfang von Hochfrequenzsignalen und eine zur Durchführung eines erfindungsgemäßen Verfahrens ausgebildete Steuereinrichtung 9. In der Figur 5 sind diese Teileinheiten der Magnetresonanzanlage 1 nur grob schematisch dargestellt. Insbesondere besteht die Hochfrequenzeinheit 7 aus mehreren Untereinheiten, insbesondere aus mindestens zwei Spulen wie den schematisch gezeigten Spulen 7.1 und 7.2, die entweder nur zum Senden von Hochfrequenzsignalen oder nur zum Empfangen der ausgelösten Hochfrequenzsignale oder für beides ausgestaltet sein können.

Zur Untersuchung eines Untersuchungsobjektes U, beispielsweise eines Patienten oder auch eines Phantoms, kann dieses auf einer Liege L in die Magnetresonanzanlage 1 in deren Messvolumen eingebracht werden. Die Schichten S1 und S2 stellen exemplarisch zwei unterschiedlichen Schichten S1 und S2 des Untersuchungsobjekts dar, die bei einer Aufnahme von MR-Signalen gleichzeitig gemessen werden können.

Die Steuereinrichtung 9 dient der Steuerung der Magnetresonanzanlage und kann insbesondere die Gradienteneinheit 5 mittels einer Gradientensteuerung 5' und die Hochfrequenzeinheit 7 mittels einer Hochfrequenz-Sende-/Empfangs-Steuerung 7' steuern. Die Hochfrequenzeinheit 7 kann hierbei mehrere Kanäle umfassen, auf denen Signale gesendet oder empfangen werden können.

Die Hochfrequenzeinheit 7 ist zusammen mit ihrer Hochfrequenz-Sende-/Empfangs-Steuerung 7' für die Erzeugung und das Einstrahlen (Senden) eines Hochfrequenz-Wechselfeldes zur Manipulation der Spins in einem zu manipulierenden Bereich (insbesondere in verschiedene Schichten S1 und S2) des Untersuchungsobjekt U zuständig. Dabei sollte die Mittenfrequenz des auch als B1-Feld bezeichneten Hochfrequenz-Wechselfeldes nahe der Resonanzfrequenz der zu manipulierenden Spins liegen. Zur Erzeugung des B1-Feldes werden in der Hochfrequenzeinheit 7 mittels der Hochfrequenz-sende/empfangs-Steuerung 7' gesteuerte Ströme an den HF-Spulen angelegt. Eine Multi-Band-RF-Pulseinheit 7a, die beispielsweise von der Hochfrequenz-Sende-/Empfangs-Steuerung 7' umfasst sein kann, berechnet Multi-Band-RF-Pulse zur gleichzeitigen Manipulation von verschiedenen Schichten S1, S2 in dem Untersuchungsobjekt U.

Weiterhin umfasst die Steuereinrichtung 9 eine Phasenbestimmungseinheit 15 insbesondere zum Bestimmen von erfindungsgemäß zusätzlich aufzuprägenden Phasen für die jeweiligen verschiedenen Abtastschemata.

Eine von der Steuereinrichtung 9 umfasste Recheneinheit 13 ist dazu ausgebildet alle für die nötigen Messungen und Bestimmungen nötigen Rechenoperationen auszuführen. Hierzu benötigte oder hierbei ermittelte Zwischenergebnisse und Ergebnisse können in einer Speichereinheit S der Steuereinrichtung 9 gespeichert werden. Die dargestellten Einheiten sind hierbei nicht unbedingt als physikalisch getrennte Einheiten zu verstehen, sondern stellen lediglich eine Untergliederung in Sinneinheiten dar, die aber auch z.B. in weniger oder auch in nur einer einzigen physikalischen Einheit realisiert sein können.

Über eine Ein-/Ausgabeeinrichtung E/A der Magnetresonanzanlage 1 können, z.B. durch einen Nutzer, Steuerbefehle an die Magnetresonanzanlage geleitet werden und/oder Ergebnisse der Steuereinrichtung 9 wie z.B. Bilddaten angezeigt werden.

Ein hierin beschriebenes Verfahren kann auch in Form eines Computerprogrammprodukts vorliegen, welches ein Programm umfasst und das beschriebene Verfahren auf einer Steuereinrichtung 9 implementiert, wenn es auf der Steuereinrichtung 9 ausgeführt wird. Ebenso kann ein elektronisch lesbarer Datenträger 26 mit darauf gespeicherten elektronisch lesbaren Steuerinformationen vorliegen, welche zumindest ein solches eben beschriebenes Computerprogrammprodukt umfassen und derart ausgestaltet sind, dass sie bei Verwendung des Datenträgers 26 in einer Steuereinrichtung 9 einer Magnetresonanzanlage 1 das beschriebene Verfahren durchführen.

**Patentansprüche**

1. Verfahren zur Erzeugung von Messdaten eines Untersuchungsobjektes mittels Magnetresonanztechnik, umfassend die Schritte:

   a) Wiederholtes Einstrahlen mindestens eines RF-Anregungspulses, wobei die eingestrahlten RF-Anregungspulse mindestens zwei sich nicht überschneidende Schichten in dem Untersuchungsobjekt selektiv anregen, und Schalten von Gradienten derart, dass durch die geschalteten Gradienten und die eingestrahlten RF-Anregungspulse Echosignale in den mindestens zwei Schichten erzeugt werden, und derart dass die erzeugten Echosignale als Messdaten in je einem Messdatensatz pro Wiederholung gemäß je einem anderen dreidimensional betrachteten Abtastschema pro Wiederholung im k-Raum aufgenommen und gespeichert werden, wobei jedes angewandte Abtastschema zwar gemäß Nyquist unterabgetastet ist, und wobei aber eine Kombination der in den Wiederholungen angewandten Abtastschemata zumindest in einem zentralen Bereich den k-Raum vollständig abtastet,
   b) Bestimmen von Kalibrierungsdaten aus Messdaten der gespeicherten Messdatensätze aus dem vollständig abgetasteten zentralen Bereich des k-Raums,
   c) Rekonstruieren von Bilddaten jeder der Schichten aus zumindest einem der gespeicherten Messdatensätze unter Verwendung der Kalibrierungsdaten,
   d) Wiederholen der Schritte a) und c), wobei zumindest einmal aktuelle Kalibrierungsdaten aus aktuellen Messdaten bestimmt werden, die für die Rekonstruktion von Bilddaten der Schichten aus aktuellen Messdatensätzen verwendet werden.

2. Verfahren nach Anspruch 1, wobei die verschiedenen angewandten Abtastschemata jeweils eine gleichartige Unterabtastung und aufgeprägte Verschiebung im Bildraum in Schichtrichtung aufweisen.

3. Verfahren nach einem der vorhergehenden Ansprüche, wobei die verschiedenen angewandten Abtastschemata sich durch eine, insbesondere zyklische, Permutation, insbesondere der mit zusätzlichen Phasen belegten k-Raumpositionen der Abtastschemata, voneinander unterscheiden.

4. Verfahren nach einem der Ansprüche 1 oder 2, wobei stets aktuelle Kalibrierungsdaten bestimmt werden oder, wobei bei Erfülltsein einer Triggerbedingung aktuelle Kalibrierungsdaten bestimmt werden.

**EP 3 460 501 B1**

5. Verfahren nach Anspruch 4, wobei bei Erfülltsein einer Triggerbedingung aktuelle Kalibrierungsdaten bestimmt werden, und die Triggerbedingung erfüllt ist, wenn sich eine Messbedingung durch eine Nutzereingabe ändert.

6. Verfahren nach einem der Ansprüche 4 oder 5, wobei bei Erfülltsein einer Triggerbedingung aktuelle Kalibrierungsdaten bestimmt werden, und Änderungen von Messbedingungen, insbesondere durch eine Bewegung des Untersuchungsobjekts oder messbedingt durch eine Änderung von Hardwarebedingungen der für die Messung verwendeten Magnetresonanzanlage während der Messung, detektiert werden, und die Triggerbedingung erfüllt ist, wenn die detektierte Änderung der Messbedingung einen vorgegebenen Schwellwert überschreitet.

7. Verfahren nach einem der Ansprüche 4 bis 6, wobei bei Erfülltsein einer Triggerbedingung aktuelle Kalibrierungsdaten bestimmt werden, und wobei die aufgenommenen Messdaten Diffusionsmessdaten sind und die Triggerbedingung erfüllt ist, wenn der b-Wert der Diffusionsmessung geändert wird und/oder, wenn eine Richtung geändert wird, in welche die Diffusionswerte gemessen werden.

8. Verfahren nach einem der Ansprüche 4 bis 7, wobei die Triggerbedingung durch ein manuelles Triggersignal oder jeweils nach einer vorgegebenen Zeitspanne erfüllt wird.

9. Verfahren nach einem der vorhergehenden Ansprüche, wobei aus bestimmten Kalibrierungsdaten (KD) dreidimensionale Kalibrierungsdatensätze (3DSi.m) erstellt werden, mit welchen die unterabgetastet aufgenommenen Messdatensätze (MDSi.m) ergänzt werden.

10. Verfahren nach einem der Ansprüche 1 bis 8, wobei aus den bestimmten Kalibrierungsdaten Schichttrennungsdaten (SKDi.m) zur Trennung der in den aufgenommenen Messdaten enthaltenen Signale in Schichtmessdatensätze (SMDSi.N.m) der jeweiligen Schichten (S1, S2, ..., SN) bestimmt werden.

11. Verfahren nach Anspruch 10, wobei die Schichtmessdatensätze (SMDSi.N.m) immer noch unterabgetastet sind und aus den bestimmten Kalibrierungsdaten (KD) Ergänzungsdaten (ErgDi.m) zur Ergänzung der Schichtmessdatensätze (SMDSi.N.m) zu vollständigen Schichtmessdatensätzen (SMDSi.N.m') bestimmt werden.

12. Verfahren nach Anspruch 10 oder 11, wobei eine Reihenfolge, in welcher die verschiedenen Abtastschemata für aufeinanderfolgende Aufnahmen von Messdaten verwendet werden, derart gewählt ist, dass nacheinander aufgenommene in zumindest dem zentralen Bereich kombinierte Messdaten sich zunächst in Schichtrichtung gegenseitig vervollständigen und erst nachranging in anderen Richtungen.

13. Magnetresonanzanlage (1) umfassend, eine Magneteinheit (3), eine Gradienteneinheit (5), eine Hochfrequenzeinheit (7) und eine Steuereinrichtung (9) mit einer Hochfrequenz-Sende-/Empfangs-Steuerung (7') und einer Phasenbestimmungseinheit (15), wobei die Steuereinrichtung (9) dazu ausgebildet ist, ein Verfahren nach einem der Ansprüche 1 bis 12 auf der Magnetresonanzanlage (1) auszuführen.

14. Computerprogramm, welches direkt in einen Speicher einer Steuereinrichtung (9) einer Magnetresonanzanlage (1) ladbar ist, mit Programm-Mitteln, um die Schritte des Verfahrens nach einem der Ansprüche 1 bis 12 auszuführen, wenn das Programm in der Steuereinrichtung (9) der Magnetresonanzanlage (1) ausgeführt wird.

15. Elektronisch lesbarer Datenträger mit darauf gespeicherten elektronisch lesbaren Steuerinformationen, welche zumindest ein Computerprogramm nach Anspruch 13 umfassen und derart ausgestaltet sind, dass sie bei Verwendung des Datenträgers in einer Steuereinrichtung (9) einer Magnetresonanzanlage (1) ein Verfahren nach einem der Ansprüche 1 bis 12 durchführen.

**Claims**

1. Method for generating measurement data from a subject under examination by means of magnetic resonance technology, comprising the following steps:

a) repeatedly applying at least one RF excitation pulse, wherein the applied RF excitation pulses selectively excite at least two non-overlapping slices in the subject under examination, and switching gradients in such a way that echo signals are generated in the at least two slices by the switched gradients and the applied RF excitation pulses, and in such a way that the generated echo signals are acquired in k-space as measurement data in one measurement dataset per repetition on the basis of one different three-dimensionally viewed sampling pattern per repetition, and stored, wherein each sampling pattern employed is undersampled according to Nyquist, and wherein, however, a combination of the sampling patterns employed in the repetitions fully samples k-space at least in a central region;

b) determining calibration data from measure-

11

ment data of the stored measurement datasets from the fully sampled central region of k-space;

c) reconstructing image data for each of the slices from at least one of the stored measurement datasets using the calibration data;

d) repeating steps a) and c), wherein latest calibration data is determined at least once from latest measurement data, which is used for reconstructing image data for the slices from latest measurement datasets.

2. Method according to claim 1, wherein the different sampling patterns employed each have identical undersampling and applied shift in image space in the slice direction.

3. Method according to one of the preceding claims, wherein the different sampling patterns employed differ from one another by a permutation, in particular a cyclic permutation, in particular of the k-space positions of the sampling patterns assigned additional phases.

4. Method according to one of claims 1 or 2, wherein latest calibration data is always determined, or wherein latest calibration data is determined on fulfilment of a trigger condition.

5. Method according to claim 4, wherein latest calibration data is determined on fulfilment of a trigger condition, and the trigger condition is fulfilled when a measurement condition is changed by a user input.

6. Method according to one of claims 4 or 5, wherein latest calibration data is determined on fulfilment of a trigger condition, and changes in measurement conditions are detected, in particular changes during the measurement caused by a movement of the subject under examination or, as a result of the measurement, caused by a change in hardware conditions of the magnetic resonance system used for the measurement, and the trigger condition is fulfilled when the detected change in the measurement condition exceeds a specified threshold value.

7. Method according to one of claims 4 to 6, wherein latest calibration data is determined on fulfilment of a trigger condition, and wherein the acquired measurement data is diffusion measurement data and the trigger condition is fulfilled when the b-value of the diffusion measurement is changed and/or when a direction in which the diffusion values are measured is changed.

8. Method according to one of claims 4 to 7, wherein the trigger condition is fulfilled by a manual trigger signal or whenever a specified time interval has passed.

9. Method according to one of the preceding claims, wherein three-dimensional calibration datasets (3DSi.m) are produced from determined calibration data (KD) and are used to replenish the measurement datasets (MDSi.m), which have been acquired in undersampled form.

10. Method according to one of claims 1 to 8, wherein slice separation data (SKDi.m) for separating the signals contained in the acquired measurement data into slice measurement datasets (SMDSi.N.m) for the respective slices (S1, S2, ..., SN) is determined from the determined calibration data.

11. Method according to claim 10, wherein the slice measurement datasets (SMDSi.N.m) are still in undersampled form, and replenishment data (ErgDi.m) for replenishing the slice measurement datasets (SMDSi.N.m) to produce complete slice measurement datasets (SMDSi.N.m') is determined from the determined calibration data (KD).

12. Method according to claim 10 or 11, wherein a sequence in which the different sampling patterns are used for successive acquisitions of measurement data is selected such that successively acquired measurement data, which is combined at least in the central region, mutually provide complete measurement data in the slice direction initially, and in other directions only subsequently.

13. Magnetic resonance system (1) comprising a magnet unit (3), a gradient unit (5), a radio frequency unit (7) and a control device (9) comprising a radio frequency transmit/receive controller (7') and a phase determination unit (15), wherein the control device (9) is designed to implement a method according to one of claims 1 to 12 on the magnetic resonance system (1).

14. Computer program, which can be loaded directly into a memory of a control device (9) of a magnetic resonance system (1), and has program means in order to perform the steps of the method according to one of claims 1 to 12 when the program is executed in the control device (9) of the magnetic resonance system (1).

15. Electronically readable data storage medium comprising electronically readable control information stored thereon, which information comprises at least one computer program according to claim 13 and is designed such that when the data storage medium is used in a control device (9) of a magnetic resonance system (1), it performs a method according to one of claims 1 to 12.

**Revendications**

1. Procédé de production de données de mesure d'un objet à examiner au moyen de la technique par résonnance magnétique, comprenant les stades :

   a) Injection répétée d'au moins une impulsion d'excitation RF, l'impulsion d'excitation RF injectée excitant sélectivement dans l'objet en examen au moins deux tranches qui ne se recoupent pas, et mise en œuvre de gradients de manière à produire par les gradients mis en œuvre et les impulsions d'excitation RF injectées, des signaux d'écho dans les au moins deux tranches et de manière à ce que les signaux d'échos produits soient enregistrés dans l'espace k et mis en mémoire sous la forme de données de mesure dans respectivement un ensemble de données de mesure par répétition suivant respectivement un autre schéma de balayage considéré en trois dimensions, chaque schéma de balayage utilisé étant certes sous-balayé suivant Nyquist mais dans lequel une combinaison des schémas de balayage utilisés dans les répétitions balayant complètement l'espace k au moins dans une partie centrale,
   b) détermination de données d'étalonnage à partir de données de mesure des ensembles de données de mesure mis en mémoire à partir de la partie centrale balayée complètement de l'espace k,
   c) reconstruction de données d'image de chacune des tranches à partir d'au moins l'un des ensembles de données de mesure mis en mémoire en utilisant les données d'étalonnage,
   d) répétition des stades a) et c), dans laquelle des données d'étalonnage en cours sont déterminées au moins une fois à partir de données de mesure en cours, qui sont utilisées pour la reconstruction de données d'image des tranches à partir des ensembles de données d'image en cours.

2. Procédé suivant la revendication 1, dans lequel les divers schémas de balayage utilisés ont chacun un sous-balayage de même type et un décalage marqué dans l'espace d'image dans la direction de tranche.

3. Procédé suivant l'une des revendications précédentes, dans lequel les divers schémas de balayage utilisés se distinguent les uns des autres par une permutation notamment cyclique, notamment des positions dans l'espace k, occupées par des phases supplémentaires, des schémas de balayage.

4. Procédé suivant l'une des revendications 1 à 2, dans lequel on détermine toujours des données d'étalonnage en cours ou dans lequel, lorsqu'une condition de déclenchement est satisfaite, on détermine des données d'étalonnage en cours.

5. Procédé suivant la revendication 4, dans lequel, si la condition de déclenchement est satisfaite, on détermine des données d'étalonnage en cours et la condition de déclenchement est satisfaite, si une condition de mesure se modifie par une entrée d'utilisation.

6. Procédé suivant la revendication 4 ou 5, dans lequel, lorsqu'une condition de déclenchement est satisfaite, on détermine des données d'étalonnage en cours et on détecte des variations des conditions de mesure, notamment par un déplacement de l'objet en examen ou dues à le mesure par une modification des conditions matérielles de l'installation de résonnance magnétique utilisée pour la mesure et la condition de déclenchement est satisfaite si la variation détectée de la condition de mesure dépasse une valeur de seuil donnée à l'avance.

7. Procédé suivant l'une des revendications 4 à 6, dans lequel, lorsqu'une condition de déclenchement est satisfaite, on détermine des données d'étalonnage en cours et dans lequel les données de mesure enregistrées sont des données de mesure de diffusion et la condition de déclenchement est satisfaite si l'on modifie la valeur b de la mesure de diffusion et/ou si l'on modifie une direction dans laquelle les valeurs de diffusion sont mesurées.

8. Procédé suivant l'une des revendications 4 à 7, dans lequel on satisfait la condition de déclenchement par un signal de déclenchement manuel ou respectivement après un laps de temps donné à l'avance.

9. Procédé suivant l'une des revendications précédentes, dans lequel on établit à partir des données (KD) d'étalonnage déterminées des ensembles (3DSi.m) de données d'étalonnage en trois dimensions, par lesquels on complète les ensembles (MDSi.m) de données de mesure enregistrés sous-balayés.

10. Procédé suivant l'une des revendications 1 à 8, dans lequel on détermine, à partir des données d'étalonnage déterminées, des données (SKDi.m) de séparation de tranche pour la séparation des signaux contenus dans les données de mesure enregistrées en ensembles (SMDSi.N.m) de données de mesure des tranches (S1, S2, ..., SN) respectives.

11. Procédé suivant la revendication 10, dans lequel les ensembles (SMDSi.N.m) de données de mesure de tranche sont pourtant sous-balayées et à partir des données (KD) d'étalonnage déterminées, on détermine des données (ErgDi.m) de complément pour compléter les ensembles (SMDSi.N.m) de données de mesure de tranche en des ensembles (SMDSi.N.m') de données de mesure de tranche complets.

12. Procédé suivant la revendication 10 ou 11, dans lequel on choisit une suite dans laquelle les divers schémas de balayage sont utilisés pour des enregistrements successifs de données de mesure, de manière à ce que des données de mesure enregistrées les unes après les autres combinées dans au moins la partie centrale se complètent d'abord mutuellement dans la direction de tranche et se complètent d'une manière subordonnée dans d'autres directions.

13. Installation (1) à résonnance magnétique comprenant une unité (3) d'aimant, une unité (5) de gradient, une unité (7) de haute fréquence et une unité (9) de commande, comprenant une commande (7') d'émission / réception de haute fréquence et une unité (15) de détermination de phase, l'unité (9) de commande étant constituée pour effectuer un procédé suivant l'une des revendications 1 à 12 sur l'installation (1) à résonnance magnétique.

14. Programme d'ordinateur, qui peut être chargé directement dans une mémoire d'un dispositif (9) de commande d'une installation (1) à résonnance magnétique, comprenant des moyens de programme pour effectuer les stades du procédé suivant l'une des revendications 1 à 12, lorsque le programme est réalisé dans le dispositif (9) de commande de l'installation (1) à résonnance magnétique.

15. Support de données, déchiffrable électroniquement, sur lequel sont mises en mémoire des informations de commande déchiffrables électroniquement, qui comprennent au moins un programme d'ordinateur suivant la revendication 13 et qui sont conformées de manière à ce qu'elles effectuent, lors de l'utilisation du support de données dans un dispositif (9) de commande d'une installation (1) à résonnance magnétique, un procédé suivant l'une des revendications 1 à 12.

FIG 1

FIG 2

FIG 3

FIG 4

EP 3 460 501 B1

FIG 5

18

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102016218955
- US 262233 A
- DE 102017201477

**In der Beschreibung aufgeführte Nicht-Patentliteratur**

- **BREUER et al.** Controlled Aliasing in Parallel Imaging Results in Higher Acceleration (CAIPIRINHA) for Multi-Slice Imaging. *Magnetic Resonance in Medicine,* 2005, vol. 53, 684-691
- **SETSOMPOP et al.** Blipped-Controlled Aliasing in Parallel Imaging for Simultaneous Multislice Echo Planar Imaging With Reduced g-Factor Penalty. *Magnetic Resonance in Medicine,* 2012, vol. 67, 1210-1224
- **ZAHNEISEN et al.** Three-Dimensional Fourier Encoding of Simultaneously Excited Slices: Generalized Acquisition and Reconstruction Framework. *Magn. Reson. Med.,* 2014, vol. 71, 2071-2081
- **BREUER.** Dynamic Autocalibrated Parallel Imaging Using Temporal GRAPPA (TGRAPPA). *Magnetic Resonance in Medicine,* 2005, vol. 53, 981-985
- **ZHU K et al.** Simultaneous Multislice Flyback Echo Planar Imaging with Auto-calibraton. *Proceedings of the ISMRM,* 07. April 2013